# EUROPEAN PATENT APPLICATION

(11) **EP 4 198 166 A1**
(43) Date of publication of application: **21.06.2023**
(21) Application number: 21910481.7
(22) Date of filing: 14.12.2021
(51) Int. Cl.: C23C 16/14, H05H 1/46

(54) **METAL FILM ALD DEVICE**

(30) Priority: 23.12.2020 JP 2020214038
(71) Applicant: Creative Coatings Co., Ltd., Tokyo, 113-0023 (JP)
(72) Inventor: SATO Eiji, Tokyo 162-0842 (JP); SAKAMOTO Hitoshi, Tokyo 162-0842 (JP)
(74) Representative: Wunderlich & Heim Patentanwälte Partnerschaftsgesellschaft mbB
(86) International application number: PCT/JP2021/046077
(87) International publication number: WO 2022/138332

(57) **Abstract**

An ALD device (10A, 10B) includes a first precursor generator (50A, 50B) that is connected to a processing gas source (30, 31) and generates a first precursor to be supplied to a reactor vessel (20), and a second precursor generator (60) that is connected to a reducing gas source (30, 32) and the reactor vessel and generates a second precursor to be supplied to the reactor vessel. The first precursor generator etches a target (53) by a first plasma (P1) excited by a first plasma generating means (53) and supplies a compound gas containing a metallic component as the first precursor. The second precursor generator supplies radicals of a reducing gas component in a second plasma (P2) excited by a second plasma generating means (64) as the second precursor.

## Description

### TECHNICAL FIELD

The present invention relates to an ALD device for a metallic film using a solid metallic material.

### BACKGROUND ART

Patent Document 1 discloses an atomic layer deposition (ALD) method capable of forming an oxide thin film on a film-forming object at a room temperature but does not disclose film formation of a metallic film. Patent Documents 2 to 5 describe film formation of a metallic film by the ALD.

### RELATED-ART DOCUMENT

### PATENT DOCUMENT

Patent Document 1: JP-B-5761724
Patent Document 2: JP-A-2020-084253
Patent Document 3: JP-A-2015-042781
Patent Document 4: JP-A-2005-322668
Patent Document 5: JP-A-2005-002099

### SUMMARY OF THE INVENTION

### TECHNICAL PROBLEM

Patent Document 2 describes that a metallic film is formed by alternately repeating supply of an organometallic compound gas and supply of a reducing gas with purges interposed therebetween. Although metals such as titanium (Ti), tantalum (Ta), and tungsten (W) are listed for examples of the organometallic compound gas, there is specific description only about formation of a metal nitride film such as TaN using ammonia (NH3) as the reducing gas. Patent Document 4 only mentions formation of a metal nitride film or a metal oxide film.

Patent Document 3 discloses the ALD for depositing a certain metallic film of ruthenium or cobalt using a metal dihydropyrazinyl complex. Patent Document 5 discloses a method of depositing metal on a substrate by the ALD method using a metal coordination complex of a 1-azaallyl metal compound as a volatile precursor. Unfortunately, Patent Document 3 and Patent Document 5 are necessary to use specific metal coordination complexes, and the types of metals to be formed as a film are also limited in relation to specific metal complexes.

An object of the invention is to provide an ALD device for forming a metallic film using a solid metallic material.

### SOLUTION TO PROBLEM

(1) In accordance with one of some embodiments, there is provided an ALD device for a metallic film, comprising:
   a reactor vessel for forming the metallic film on a workpiece, the reactor vessel being alternately charged with a first precursor and a second precursor for performing an ALD cycle;
   a processing gas source;
   a reducing gas source;
   a first precursor generator that is connected to the processing gas source and generates the first precursor to be supplied to the reactor vessel; and
   a second precursor generator that is connected to the reducing gas source and generates the second precursor to be supplied to the reactor vessel, wherein
   the first precursor generator includes a first plasma generating means and a target containing a metallic component each outside the reactor vessel, etches the target by a first plasma obtained by exciting a processing gas from the processing gas source by the first plasma generating means so as to generate a compound gas containing the metallic component, and supplies the compound gas to the reactor vessel as the first precursor, and
   the second precursor generator includes a second plasma generating means outside the reactor vessel, and supplies radicals of a reducing gas component in a second plasma obtained by exciting a reducing gas from the reducing gas source by the second plasma generating means to the reactor vessel as the second precursor.
   According to one aspect of the invention, the first precursor can be obtained by etching the target by the first plasma to generate the compound gas containing the metallic component in the target. The type of the metal of the chemically etched target is not limited to specific one. The first precursor adhering to the workpiece is reduced by the radicals of the reducing gas component that is the second precursor, so that the metal is deposited on the workpiece. In this reduction phenomenon, the reaction is promoted even at a room temperature. Hence, the workpiece is unnecessary to be forcibly heated during the film formation. Accordingly, the film of the metal of the target may be formed on the workpiece at a room temperature by the ALD.
(2) In accordance with one of some aspect, there is provided the ALD device for the metallic film according to the aspect (1), wherein
   the first precursor generator may include a pipeline that connects the processing gas source and the reactor vessel together, the pipeline including a non-metallic portion,
   the first plasma generating means may be arranged around the non-metallic portion of the pipe line, and
   the target may be a bar-shaped target that is arranged inside the non-metallic portion of the pipeline along a longitudinal direction of the pipeline.
   With this, the bar-shaped target etched by the first plasma can be suppressed from hindering the gas flow in the pipeline.
(3) In accordance with one of some aspect, there is provided the ALD device for the metallic film according to the aspect (1), wherein
   the first precursor generator may include a pipeline that connects the processing gas source and the reactor vessel together, the pipeline including a non-metallic portion,
   the first plasma generating means may be arranged around the non-metallic portion of the pipeline, and
   a distance between the first plasma inside the pipeline and the reactor vessel may be not less than a product of a life span of radicals in the first plasma and a flow rate of the processing gas.
   With this, the radicals present in the first plasma meets the life span thereof before reaching the reactor vessel, so that the introduction of the radicals into the reactor vessel is suppressed. As a result, the reaction between the first precursor and the radicals that are simultaneously introduced into the reactor vessel is suppressed, so that the film formation on the workpiece due to the CVD can be suppressed.
(4) In accordance with one of some aspect, there is provided the ALD device for the metallic film according to any one of the aspects (1) to (3), wherein
   each of the processing gas and the reducing gas may be a halogen gas,
   the target may be a metal that is the same as the metallic film, and
   the first precursor may be a halogen compound gas containing the metallic component.
   With this, in the first precursor generator, the metallic target is etched to generate the halogen compound as the first precursor. The halogen compound adheres to the workpiece in the reactor vessel, and then the halogen compound is reduced by the halogen radicals that are the second precursor, so that the metal is deposited on the workpiece.
(5) In accordance with one of some aspect, there is provided the ALD device for the metallic film according to the aspect (4), wherein C × F/S < 1 × 10¹⁹ may be established, where S (m²) is an area of a target surface of the target and C (pieces/m³) and F (m³/min) are a concentration and a flow rate of the halogen gas, respectively.
   With this, almost all the halogen gas is consumed by generating the halogen compound. Thus, the second precursor (halogen radicals) introduced together with the first precursor into the reactor vessel decrease in quantity. Accordingly, it is possible to suppress the film formation on the workpiece due to the CVD.
(6) In accordance with one of some aspect, there is provided the ALD device for the metallic film according to the aspect 4 or 5, wherein the second precursor generator may include a non-metallic pipe in which the second plasma is generated by the second plasma generating means and a metallic pipe in which halogen ions in the second plasma are selectively removed using electric charges of the halogen ions, the metallic pipe being located downstream of the second plasma generating means.
   The metallic pipe can selectively remove the halogen ions using the electric charges of the halogen ions while allowing movement of the electrically neutral halogen radicals. In this manner, the halogen ions likely to etch the reactor vessel physically and chemically can be suppressed from being introduced into the reactor vessel.
(7) In accordance with one of some aspect, there is provided the ALD device for the metallic film according to the aspect (6), wherein the metallic pipe may be grounded.
   The halogen ions are likely to become anions in the liquid, but mostly, for example, up to 90% become cations in the gas. The cations are adsorbed by the grounded metallic pipe, and missing electrons are injected from the ground and neutralized. Anions that have come in contact with the grounded metallic pipe releases excess electrons to the ground, to be neutralized. In this manner, the halogen ions, which are cations or anions, are removed using their electric charges.
(8) In accordance with one of some aspect, there is provided the ALD device for the metallic film according to the aspect (6), wherein the metallic pipe may be connected to an AC power source that applies AC voltage.
   In this configuration, cations are adsorbed to the metallic pipe when negative voltage is applied to the metallic pipe, anions are adsorbed to the metallic pipe when positive voltage is applied to the metallic pipe, and excessive or deficient electrons are emitted/injected from the metallic pipe, to be neutralized. In this manner, the halogen ions, which are cations or anions, are removed using their electric charges.
(9) In accordance with one of some aspect, there is provided the ALD device for the metallic film according to any one of the aspects (6) to (8), wherein the metallic pipe may include a bent part that bends a flow passage.
   This makes it easier for the halogen ions to come into contact with the inner wall of the bent part of the metallic pipe, to thereby easily remove the halogen ions.
(10) In accordance with one of some aspect, there is provided the ALD device for the metallic film according to any one of the aspects (1) to (3), wherein the target may include a first portion and a second portion, and in this case, the first portion may be the metallic oxide containing the metallic component, and the second portion may be carbon. When the processing gas is an inert gas, the first precursor may be metal acetylide containing the metallic component. The metal acetylide that is the first precursor is reduced by the reducing gas that is the second precursor. In this manner, the metal acetylide of a metal other than alkali metals can be generated by heating the metal oxide and the carbon. The target may be inductively heated by the second plasma generating means. With this, metal of any type other than the alkali metals that can form the metal acetylide can be formed as a metallic film on the workpiece by reducing the metal acetylide.
(11) In accordance with one of some aspect, the ALD device for the metallic film according to any one of the aspects (1) to (4) or (10) may include a precursor generator used as both the first precursor generator and the second precursor generator. In this case, the precursor generator may include a plasma generating means used as both the first plasma generating means and the second plasma generating means, and a switching mechanism that switches between a state in which a plasma excited by the plasma generating means etches the target and a state in which the plasma does not etch the target. In this manner, the single precursor generator may be used as both the first precursor generator and the second precursor generator.

### BRIEF DESCRIPTION OF THE DRAWINGS

FIG. 1 is a schematic explanatory view of an ALD device according to the first embodiment of the invention.
FIG. 2 is a timing chart for explaining an ALD method of the first embodiment.
FIG. 3 is a view for explaining a modification of the first embodiment.
FIG. 4 is a schematic explanatory view of an ALD device according to the second embodiment of the invention.
FIG. 5 is a schematic explanatory view of a modification of the ALD device according to the second embodiment of the invention.
FIG. 6 is a schematic explanatory view showing a state in which a target in FIG. 5 is moved.

### DESCRIPTION OF EMBODIMENTS

The following disclosure provides many different embodiments and examples for implementing different features of the presented subject matter. Of course, these are merely examples and are not intended to be limiting. Further, the disclosure might repeat reference numbers and/or letters in various instances. This repetition is for the sake of providing brief and clear description, and does not require a relationship between the various embodiments and/or described configurations. Further, when it is described that a first element is "connected" or "coupled" to a second element, such description includes embodiments in which the first element and the second element are integral or in which the first element and the second element are directly connected or coupled to each other, and further includes embodiments in which the first element and the second element are indirectly connected or coupled to each other with one or more other elements interposed therebetween. In addition, when it is described that the first element "moves" relative to the second element, such description includes embodiments related to a relative movement in which at least one of the first element and the second elements moves relative to the other.

### 1. First Embodiment

### 1.1. ALD device 10A

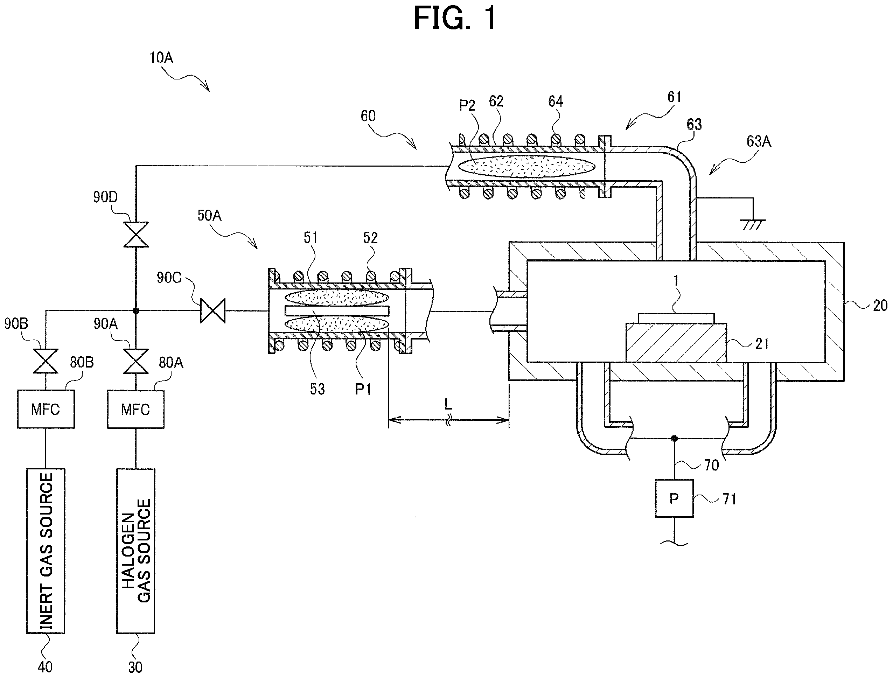

FIG. 1 shows an example of an ALD device 10A. The ALD device 10A includes a reactor vessel 20, a halogen gas source 30, an inert gas source 40, a first precursor generator 50A, and a second precursor generator 60. The halogen gas source 30 serves as a processing gas source and a reducing gas source in the first embodiment. The inert gas source 40 is used as a carrier gas or a purge gas. The reactor vessel 20 is a vessel for forming a film on a workpiece 1. The reactor vessel 20 may include a placement part 21 on which, for example, a substrate that is the workpiece 1 is placed. When the workpiece 1 is powder or the like, the placement part 21 is unnecessary, and the powder may be at least maintained in a dispersed state within the reactor vessel 20. The first and second precursor generators 50A, 60 are connected to the reactor vessel 20, and the first precursor, the second precursor, or a cleaning gas is introduced into the reactor vessel 20. An exhaust pipe 70 is connected to the reactor vessel 20, and the inside of the reactor vessel 20 can be exhausted by an exhaust pump 71.

The halogen gas source 30 stores a halogen gas, such as a Cl₂ gas, which serves as both the processing gas and the reducing gas. A mass flow controller (MFC) 80A and a valve 90A are connected to the halogen gas source 30. The inert gas source 40 stores an inert gas, such as Ar. A mass flow controller (MFC) 80B and a valve 90B are connected to the inert gas source 40. The halogen gas source 30 and the inert gas source 40 can supply a gas to the first precursor generator 50A by opening a valve 90C and closing a valve 90D, and can supply the gas to the second precursor generator 60 by opening the valve 90D and closing the valve 90C.

The first precursor generator 50A uses the halogen gas from the halogen gas source 30 as the processing gas to generate, as the first precursor, a halogen compound such as CuCl between a metal element such as Cu and a halogen element such as Cl. The second precursor generator 60 uses the halogen gas from the halogen gas source 30 to generate halogen radicals, such as Cl radicals, as the second precursor (reducing gas).

The first precursor generator 50A includes a non-metallic pipeline 51. A first plasma generating means, for example, a first induction coil 52 is arranged around the pipeline 51. A not-shown high-frequency power supply is connected to the first induction coil 52. For example, electromagnetic energy applied by the first induction coil 52 is 20W at a frequency of 13.56 MHz. An inductively coupled plasma (e.g., Cl₂ plasma) P1 of the halogen gas is generated in the pipeline 51 by the first induction coil 52.

A metallic target 53 is arranged in the pipeline 51. The metallic target 53 is made of copper Cu, for example. The halogen gas introduced into the pipeline 51 is excited by the first induction coil 52 to generate the first plasma P1 near the metallic target 53. In particular, the metallic target 53 may be a bar-shaped target that is arranged inside a non-metallic portion of the pipeline 51 along the longitudinal direction of the pipeline 51. This configuration can suppress the metallic target 53 from hindering the gas flow in the pipeline 51.

Metal such as Cu ions, which are generated by etching the metallic target 53 by the first plasma P1, and halogen such as Cl in the first plasma P1 react with each other, to thereby generate the first precursor (e.g., CuCl that is a halogen compound). In particular, when the metallic target 53 is a bar-shaped target, the entire circumferential surface of the metallic target 53 can be worn.

The second precursor generator 60 includes a pipeline 61. A second plasma generating means, for example, a second induction coil 64 is arranged around the pipeline 61. A not-shown high-frequency power supply is connected to the second induction coil 64. For example, electromagnetic energy applied by the second induction coil 64 is 20 W at a frequency of 13.56 MHz. A second plasma P2 of the halogen gas is generated in the pipeline 61 by the second induction coil 64. The second plasma P2 includes halogen radicals (Cl*) as a reactive gas that is the second precursor.

In the present embodiment, the second precursor generator 60 is also used as a cleaning gas generator. In this case, the halogen radicals are used as a cleaning gas to clean the reactor vessel 20 after the ALD process is completed. As this cleaning gas, the halogen radicals in the second plasma P2 may be used, the halogen radicals being obtained by exciting the halogen gas supplied from the halogen gas source 30 by the second induction coil 64.

In this case, a region 62 in the pipeline 61 where the second induction coil 64 is arranged is made of non-metal such as quartz, for example. In this embodiment, the pipeline 61 can have a metallic pipe 63 as an ion removing means located downstream of the second induction coil 64. In this embodiment, for example, a stainless steel pipe is used as the metallic pipe 63 of the pipeline 61 connected to the quartz pipe 62. The metallic pipe 63 may include a bent part 63A that bends a flow passage. In addition, in this embodiment, the metallic pipe 63 is grounded.

### 1.2. ALD method

### 1.2.1. ALD cycle

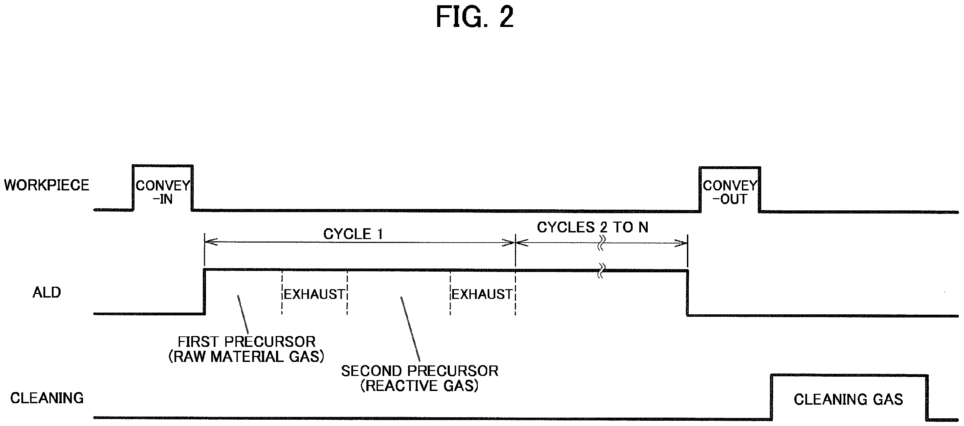

As shown in FIG. 2, first, the workpiece 1 is conveyed into the reactor vessel 20. Then, an ALD cycle is carried out. As shown in FIG. 2, the ALD cycle is defined by one cycle including at least the following four steps: loading of the first precursor (a raw material gas) -> exhaust (including the purge) -> loading of the second precursor (the reactive gas or the reducing gas) -> exhaust (including the purge). Note that the exhaust means evacuation by the exhaust pump 71, the purge means supply of the inert gas (purge gas) from the inert gas source 40, and in either case, inside the reactor vessel 20, a first or second precursor atmosphere is replaced with a vacuum or purge gas atmosphere. The thickness of the film formed on the workpiece 1 is proportional to the number N of the ALD cycles. Therefore, the ALD cycle is repeated by the necessary number N.

The type of the film formed by the ALD device 10A is a metallic film, and an example of forming a film of copper Cu will be described below, as an example of the metallic film. In performing the ALD cycle, first, the inside of the reactor vessel 20 is evacuated by the exhaust pump 71 to have a pressure of 10⁻⁴ Pa, for example. Next, as the first step of the ALC cycle, the inside of the reactor vessel 20 is charged with CuCl, which is the first precursor supplied from the first precursor generator 50A, at a predetermined pressure of 1 to 10 Pa, for example. In the first step of the ALD cycle, CuCl penetrates an exposed surface of the workpiece 1. After a predetermined time has passed, as the second step of the ALD cycle, the purge gas is introduced into the reactor vessel 20, and the first precursor in the reactor vessel 20 is replaced with the purge gas.

Next, as the third step of the ALD cycle, the inside of the reactor vessel 20 is charged with the Cl radicals, which are the second precursor from the second precursor generator 60, at a predetermined pressure of 1 to 10 Pa, for example. In the third step of the ALD cycle, the Cl radicals penetrate the exposed surface of the workpiece 1. As a result, CuCl reacts with the Cl radicals on the exposed surface of the workpiece 1, and a film of copper Cu is formed on the exposed surface of the workpiece 1 by a subsequent reduction reaction.

CuCl + Cl → Cu + Cl₂↑

In particular, between the CuCl and the Cl radicals on the exposed surface of the workpiece 1, the reduction reaction is promoted even at a room temperature. Therefore, it is unnecessary to forcibly heat the workpiece 1 during the film formation. After a predetermined time has passed, as the fourth step of the ALD cycle, the purge gas is introduced into the reactor vessel 20, and the Cl radicals in the reactor vessel 20 are replaced with the purge gas. A Cu film can be formed by about 1 angstrom = 0.1 nm per cycle; therefore, the ALD cycle may be repeated 100 times in order to obtain a film thickness of 10 nm, for example. When the ALD cycle is completed, the workpiece 1 is conveyed out from the reactor vessel 20, as shown in FIG. 2.

### 1.2.1.1. First step of ALD process

In the first step of the ALD process, it is preferable to introduce only the first precursor into the reactor vessel 20. This is because, if other gaseous components are introduced together with the first precursor into the reactor vessel 20, the other gaseous components react with the first precursor.

Here, in the first step of the ALD process, since the first plasma P1 is generated in the first precursor generator 50A, halogen ions and halogen radicals exist therein. These are consumed in the etching of the target 53; however, since the halogen radicals are the second precursor, simultaneous introduction of the first and the second precursors into the reactor vessel 20 in the first step of the ALD process results in a film formation on the workpiece 1 due to CVD. Therefore, in the first step of the ALD process, it is preferable to suppress the halogen radicals that are the second precursor from being introduced into the reactor vessel 20.

### 1.2.1.1.1. Distance L between first plasma P1 and reactor vessel 20

A distance L between the first plasma P1 and the reactor vessel 20 may be not less than a product (LS×FR) of a life span LS of the halogen radicals in the first plasma P1 and a flow rate FR of the processing gas (halogen gas). With this, the halogen radicals present in the first plasma P1 meets the life span thereof before reaching the reactor vessel 20, so that the introduction of the radicals into the reactor vessel 20 decrease in quantity. As a result, the reaction between the first precursor and the radicals that are simultaneously introduced into the reactor vessel 20 decrease in quantity, so that the film formation on the workpiece 1 due to the CVD can be suppressed. Here, if the life span LS of Cl radicals is 10 msec, and the flow rate FR of the halogen gas is 100 m/sec, for example, the distance L between the first plasma P1 and the reactor vessel 20 may be set to 1 m or more.

### 1.2.1.1.2. Relationship between target area and concentration/flow rate of processing gas

An inequality C × F/S < 1 × 10¹⁹ may be established, where S is the area of a target surface of the target 53 and C and F are the concentration and the flow rate of the halogen gas, respectively. With this, almost all of the halogen gas is consumed by generating the halogen compound. Thus, the amount of the second precursor (halogen radicals) introduced together with the first precursor into the reactor vessel 20 decrease in quantity. Accordingly, it is possible to suppress the film formation on the workpiece 1 due to the CVD. For example, when the halogen gas with a concentration (density) C = 10¹⁹ (/m³) is supplied to the target having an area S = 0.01 (m²) at a flow rate F = 10⁻⁴ (m³/min), the above inequality is established.

### 1.2.1.2. Third step of ALD process

The third step of the ALD process generates the halogen radicals in the second precursor generator 60, as described above. In other words, the halogen radicals can be generated in the second plasma P2 obtained by exciting the halogen gas from the halogen gas source 30 by the second induction coil 64. However, the second plasma P2 also contains halogen ions as in the first plasma P1. The halogen ions in the first plasma P1 are consumed in the etching of the target 53, but the halogen ions are unconsumed and remain in the second plasma P2. The halogen ions are likely to excessively etch the reactor vessel 20 physically and chemically. Therefore, in the third step of the ALD process, it is preferable to reduce the introduction of the halogen ions into the reactor vessel 20. The removal of the halogen ions in the third step of the ALD process will be described below.

### 1.2.2. Cleaning process

After the workpiece 1 is conveyed out, the cleaning process can be started. Hence, in this embodiment, the halogen gas from the halogen gas source 30 is diluted by the inert gas supplied from the inert gas source 40 to 1 to 10%, for example, and is supplied to the pipeline 61, and the halogen gas thus diluted is excited by the second induction coil 64 to generate halogen radicals, such as Cl radicals in the second plasma P2, for example. The halogen radicals react with reaction products of a thin film on the inner wall of the reactor vessel 20 to clean the reactor vessel 20. However, the halogen ions are unconsumed and remain in the second plasma P2. The halogen ions are likely to excessively etch the reactor vessel 20 physically and chemically. Therefore, it is preferable to reduce the introduction of the halogen ions into the reactor vessel 20 also in the cleaning process.

### 1.2.3. Removal of halogen ions (third step of ALD process and cleaning process)

Here, as described above, the second plasma P2 includes the halogen ions and the halogen radicals. The halogen ions mostly, for example, up to 90% become cations in the gas. The cations are adsorbed by the grounded metallic pipe 63, and missing electrons are injected from the ground and neutralized. Anions having come in contact with the grounded metallic pipe 63 release excess electrons to the ground, to be neutralized. Thus, the halogen ions, which are cations or anions, are removed in the middle of the pipeline 61 using their electric charges. In particular, the metallic pipe 63 having the bent part 63A that bends the flow passage can cause the halogen ions to collide with the inner wall of the bent part 63A. This makes it easier for the halogen ions to come into contact with the inner wall of the bent part 63A of the metallic pipe 63, to thereby easily remove the halogen ions.

In this manner, the halogen ions, which are likely to excessively etch the reactor vessel 20 and the like physically and chemically, are selectively removed in the middle of the pipeline 61 using the electric charges of the halogen ions. On the other hand, electrically neutral radicals can easily pass through the inside of the pipeline 61 and are guided into the reactor vessel 20. Hence, in the third step of the ALD process, the film formation reaction can be exerted independently by the halogen radicals. On the other hand, during the cleaning, the reactor vessel 20 is chemically etched by the halogen radicals independently; therefore, the reactor vessel 20 is cleaned without being damaged. Specifically, the halogen radicals chemically react with the film (metallic film in this embodiment) adhering to the inner wall of the reactor vessel 20 and are removed as a chloride.

The film thickness of the deposit deposited on the reactor vessel 20 by performing the ALD process is thinner as compared to those in other film forming devices. Therefore, even in the case of using a low concentration cleaning gas diluted to 1 to 10%, for example, it is possible to sufficiently perform the cleaning.

### 1.3. Modification

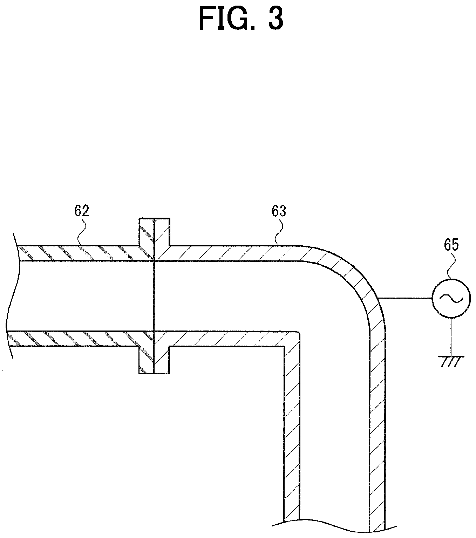

The metallic pipe 63 is not always necessary to be grounded. For example, as shown in FIG. 3, the metallic pipe 63 may be connected to an AC power source 65 that applies alternating voltage varying from -100 to +100 V at 10 to 100 Hz, for example. In this configuration, cations are adsorbed to the metallic pipe 63 when negative voltage is applied to the metallic pipe 63, anions are adsorbed to the metallic pipe 63 when positive voltage is applied to the metallic pipe 63, and excessive or deficient electrons are emitted/injected from the metallic pipe to be neutralized. In this manner, the halogen ions, which are cations or anions, are removed using their electric charges.

In the bent part 63A of the metallic pipe 63, an angle defined by respective pipes before and after the bending is preferably a right angle or an acute angle rather than an acute angle, or the pipe may be helically bent. This helps the halogen ions to be more likely to come into contact with the inner wall of the pipe, so that removal efficiency of the halogen ions becomes increased.

Furthermore, the ion removing means is not limited to one using the metallic pipe 63 as long as the ion remover can remove the halogen ions using the electric charges of the halogen ions. For example, a mesh made of charge-adsorption fibers may be arranged in the middle of the pipe. The charge-adsorption fibers may be grounded or an AC power source may be connected thereto.

As for the performing timing of the cleaning process, the cleaning process may be performed every time the ALD cycle for one workpiece 1 is completed or every time the ALD cycle for a plurality of workpieces 1 is completed. When the film formation on the workpiece 1 includes a plurality of layers of different film types, the cleaning process may be performed every time the ALD cycle for one layer in the film formation is completed or may be performed after waiting for the completion of the ALD cycle for a plurality of layers in the film formation on the same workpiece 1.

As for the ALD process, the type of metal to be formed as a film is not limited to copper, and any metal that forms a halogen compound may be used. In the meantime, the halogen may be one of five elements: fluorine(F), chlorine (Cl), bromine (Br), Iodine(I), and Astatine (At), and Cl₂ or F₂ are preferable as preferred halogen molecules for the processing gas and the cleaning gas.

### 2. Second Embodiment

### 2.1. ALD device 10B

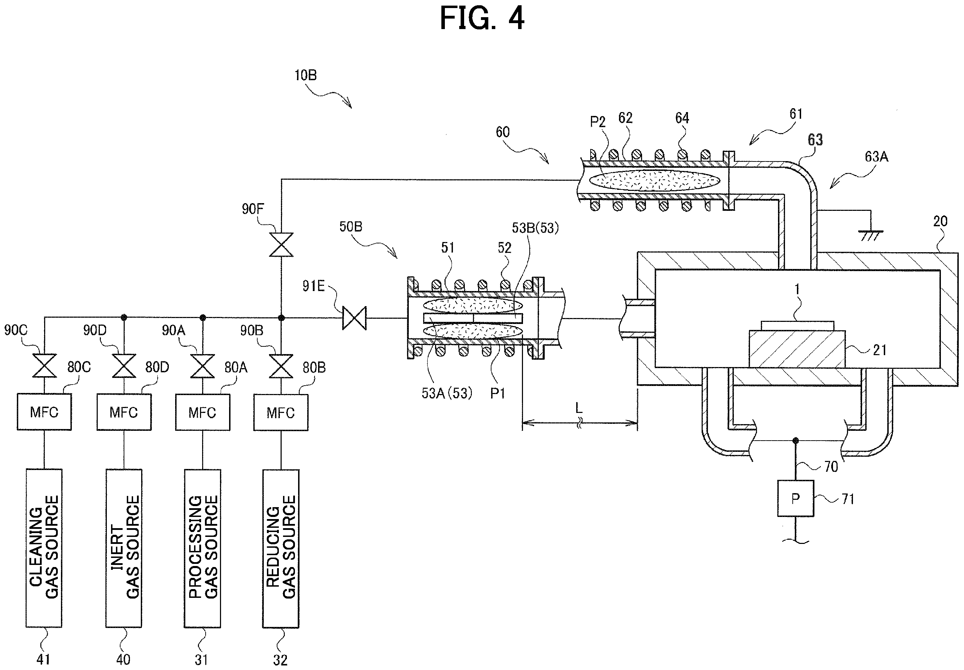

Next, the second embodiment of the invention will be described with reference to FIG. 4. The second embodiment of the invention differs from the first embodiment in that metal acetylide is used as the first precursor. Hence, an ALD device 10B shown in FIG. 4 differs from the ALD device 10A of the first embodiment in a first precursor generator 50B and gas sources. A target 53 disposed in the first precursor generator 50B includes a first portion 53A and a second portion 53B. In this case, the first portion 53A is metal oxide such as CuO, and the second portion 53B is carbon C. The first portion 53A and the second portion 53B may be integrally connected to each other as shown in FIG. 4, or may be separated as separate bodies.

In FIG. 4, a processing gas source 31, a reducing gas source 32, the inert gas source 40 and a cleaning gas source 41 are arranged. The processing gas supplied to the first precursor generator 50B may be an inert gas such as Ar and N₂, for example. Therefore, the inert gas source 40 may be omitted when the inert gas of the processing gas source 31 introduced for generating the first precursor is the same as the inert gas of the inert gas source 40 used as a carrier gas or a purge gas.

The reducing gas source 32 stores a reducing gas that reduces metal acetylide, such as hydrogen H₂. The hydrogen gas from the reducing gas source 32 is introduced into the second precursor generator 60 and is excited at the second induction coil 64 to be hydrogen radicals, which are the second precursor. The halogen gas is stored in the cleaning gas source 41 and can be supplied for the cleaning process in the same manner as in the first embodiment.

Here, in the first precursor generator 50B, the inert gas from the processing gas source 31 is excited by the first induction coil 52 to generate the first plasma P1. Ions in the first plasma P1 etch the first portion 53A and the second portion 53B of the target 53. In addition, the first induction coil 52 inductively heats the target 53. Then, metal oxide and carbon etched from the first portion 53A and the second portion 53B of the target 53 are heated, to thereby generate metal acetylide as the first precursor. For example, copper acetylide (C₂Cu₂) is generated by CuO and C etched from the target 53.

### 2.2. ALD method

Also in the second embodiment, the first to fourth steps of the ALD cycle shown in FIG. 2 are performed in the same manner as in the first embodiment. The type of a film formed by the ALD device 10B is also a metallic film, and an example of forming a film of copper Cu as an example of the metallic film will be described below. After the inside of the reactor vessel 20 is evacuated, as the first step of the ALD cycle, copper acetylide (C₂Cu₂), which is the first precursor, is generated in the first precursor generator 50B, and the inside of the reactor vessel 20 is charged with the copper acetylide at a predetermined pressure. In the first step of the ALD cycle, C₂Cu₂ penetrates the exposed surface of the workpiece 1.

After a predetermined time has passed, as the second step of the ALC cycle, the first precursor in the reactor vessel 20 is replaced with the purge gas. Next, as the third step of the ALD cycle, the inside of the reactor vessel 20 is charged with hydrogen radicals, which are the second precursor from the second precursor generator 60, at a predetermined pressure example. In the third step of the ALD cycle, hydrogen radicals penetrate the exposed surface of the workpiece 1. As a result, the copper acetylide (C₂Cu₂) reacts with the hydrogen radicals on the exposed surface of the workpiece 1, and a film of the copper Cu is formed on the exposed surface of the workpiece 1 by a subsequent reduction reaction.

C₂Cu₂ + H₂ → Cu + C₂H₂ (acetylene)↑

In particular, the reduction reaction between C₂Cu₂ and the hydrogen radicals on the exposed surface of the workpiece 1 is promoted even at a room temperature. Therefore, it is unnecessary to forcibly heat the workpiece 1 during the film formation. After a predetermined time has passed, as the fourth step of the ALD cycle, the purge gas is introduced into the reactor vessel 20, and Cl radicals in the reactor vessel 20 are replaced with the purge gas. After that, the ALD cycle is repeated as many times as necessary to obtain the required film thickness.

### 3. Third Embodiment

### 3.1. ALD device 10C

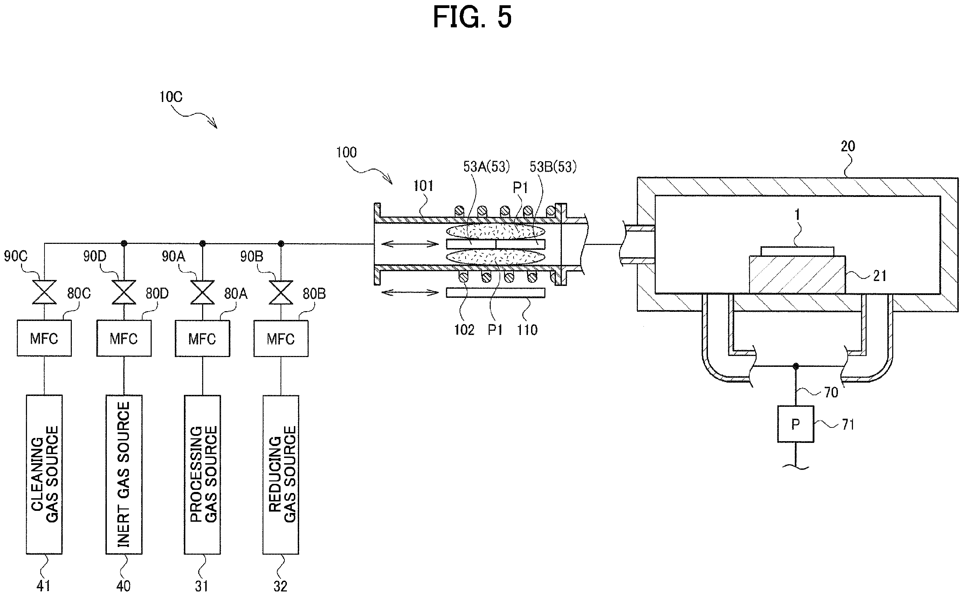

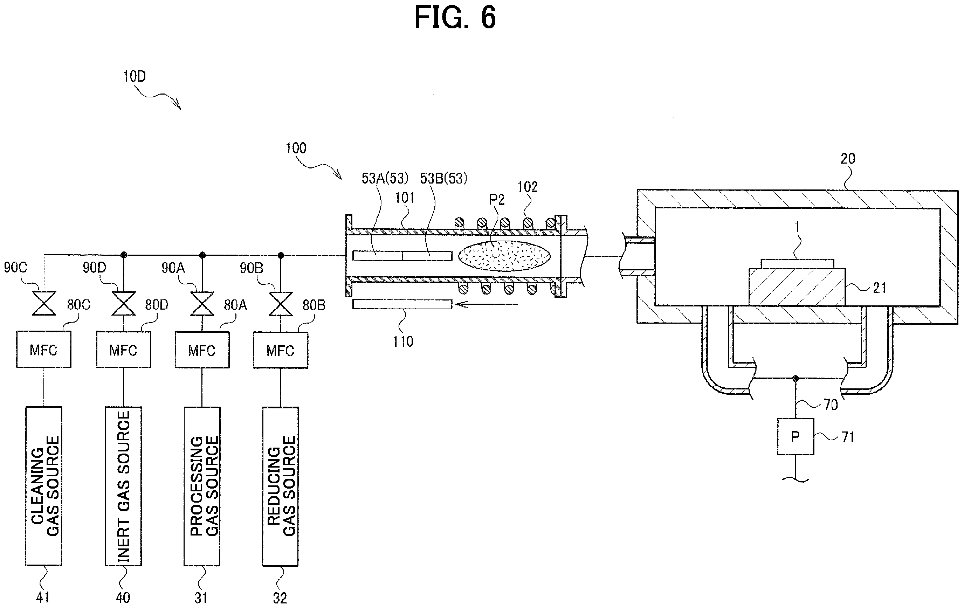

Next, the third embodiment of the invention will be described with reference to FIG. 5 and FIG. 6. In the third embodiment of the invention, a single precursor generator 100 is used as both the first precursor generator 50A or 50B used in the first or the second embodiment and the second precursor generator 60. FIG. 6 shows an example of using the single precursor generator 100 as both the first precursor generator 50B used in the second embodiment and the second precursor generator 60, and the same may apply to the first embodiment.

The precursor generator 100 shown in FIG. 5 includes a non-metallic pipeline 101 that has a length at least twice as long as the total length of the target 53, for example. For example, an induction coil is disposed as a plasma generating means 102 used as both the first plasma generating means 52 and the second plasma generating means 64, for example, around the downstream region of the pipeline 101. The precursor generator 100 may have a switching mechanism for switching the plasma excited by the plasma generating means 102 between a state in which the excited plasma etches the target 53 and a state in which the excited plasma does not etch the target 53. In FIG. 5, a magnet 110 reciprocating in a direction indicated by an arrow shown in FIG. 5 is arranged outside the pipeline 101 as the switching mechanism. The switching mechanism may further include a guide mechanism that reciprocatingly guides the target 53 inside the pipeline 101 in the arrow direction in FIG. 5. With the induction coil 102 supplied with no electricity, when the magnet 110 moves as shown in FIG. 5, the target 53 is also moved following the movement of the magnet 110.

### 3.2. ALD method

The first step of the ALD process is performed with the target 53 set at a position as shown in FIG. 5. With this, in the precursor generator 100, the target 53 is etched by the first plasma P1 excited by the induction coil 102, so that the first precursor such as copper acetylide can be generated. The third step of the ALD process is performed with the target 53 set to a position shown in FIG. 6. With this, in the precursor generator 100, the second precursor such as hydrogen radicals can be generated without the target 53 is etched by the second plasma P2 excited by the induction coil 102. Accordingly, also in the third embodiment of the invention, the metallic film can be formed in the same manner as in the second embodiment.

### 4. Modification

In the second embodiment of the invention, the second precursor generator 60 can remove ions in the same manner as in the first embodiment of the invention. In the third embodiment of the invention, the switching mechanism may move a shutter or a cover and the target relative to each other to perform switching between a state of exposing the target to the plasma and a state of not exposing the target to the plasma. In this manner, the single precursor generator 100 can be used as both the first precursor generator 50A or 50B and the second precursor generator 60. As the plasma generating means, in addition to an inductively coupled plasma generating device using DC, a radio frequency (RF), or a microwave power source, a capacitively coupled plasma generating device, an electron cyclotron resonance (ECR) plasma generating device, or a surface wave plasma generating device, for example, using microwaves may also be used.

### REFERENCE SIGNS LIST

- 1: workpiece
- 10A, 10B, 10C: ALD device
- 20: reactor vessel
- 30: halogen gas source (processing gas source and reducing gas source)
- 31: processing gas source
- 32: reducing gas source
- 40: inert gas source
- 41: cleaning gas source
- 50A, 50B: first precursor generator
- 51, 61, 101: pipeline
- 52: first plasma generating means (first induction coil)
- 53: metallic target
- 53A: first portion
- 53B: second portion
- 60: second precursor generator
- 62: quartz pipe
- 63: metallic pipe
- 63A: bent part
- 64: second plasma generating means (second induction coil)
- 65: AC power source
- 70: exhaust pipe
- 71: exhaust pump
- 80A to 80B: mass flow controller
- 90A to 90D: valve
- 100: precursor generator (first precursor generator and second precursor generator)
- 110: switching mechanism
- P1: first plasma
- P2: second plasma

## Claims

1. An ALD device for a metallic film, comprising:
a reactor vessel for forming the metallic film on a workpiece, the reactor vessel being alternately charged with a first precursor and a second precursor for performing an ALD cycle;
a processing gas source;
a reducing gas source;
a first precursor generator that is connected to the processing gas source and generates the first precursor to be supplied to the reactor vessel; and
a second precursor generator that is connected to the reducing gas source and generates the second precursor to be supplied to the reactor vessel, wherein
the first precursor generator includes a first plasma generating means and a target containing a metallic component each outside the reactor vessel, etches the target by a first plasma obtained by exciting a processing gas from the processing gas source by the first plasma generating means so as to generate a compound gas containing the metallic component, and supplies the compound gas to the reactor vessel as the first precursor, and
the second precursor generator includes a second plasma generating means outside the reactor vessel, and supplies radicals of a reducing gas component in a second plasma obtained by exciting a reducing gas from the reducing gas source by the second plasma generating means to the reactor vessel as the second precursor.

2. The ALD device for the metallic film according to claim 1, wherein
the first precursor generator includes a pipeline that connects the processing gas source and the reactor vessel together, the pipeline including a non-metallic portion,
the first plasma generating means is arranged around the non-metallic portion of the pipe line, and
the target is a bar-shaped target that is arranged inside the non-metallic portion of the pipeline along a longitudinal direction of the pipeline.

3. The ALD device for the metallic film according to claim 1, wherein
the first precursor generator includes a pipeline that connects the processing gas source and the reactor vessel together, the pipeline including a non-metallic portion,
the first plasma generating means is arranged around the non-metallic portion of the pipeline, and
a distance between the first plasma inside the pipeline and the reactor vessel is not less than a product of a life span of radicals in the first plasma and a flow rate of the processing gas.

4. The ALD device for the metallic film according to any one of claims 1 to 3, wherein
each of the processing gas and the reducing gas is a halogen gas,
the target is a metal that is the same as the metallic film, and
the first precursor is a halogen compound gas containing the metallic component.

5. The ALD device for the metallic film according to claim 4, wherein C × F/S < 1 × 10¹⁹ is established, where S (m²) is an area of a target surface of the target and C (pieces/m³) and F (m³/min) are a concentration and a flow rate of the halogen gas, respectively.

6. The ALD device for the metallic film according to claim 4 or 5, wherein the second precursor generator includes a non-metallic pipe in which the second plasma is generated by the second plasma generating means and a metallic pipe in which halogen ions in the second plasma are selectively removed using electric charges of the halogen ions, the metallic pipe being located downstream of the second plasma generating means.

7. The ALD device for the metallic film according to claim 6, wherein the metallic pipe is grounded.

8. The ALD device for the metallic film according to claim 6, wherein the metallic pipe is connected to an AC power source that applies AC voltage.

9. The ALD device for the metallic film according to any one of claims 6 to 8, wherein the metallic pipe includes a bent part that bends a flow passage.

10. The ALD device for the metallic film according to any one of claims 1 to 3, wherein
the target includes a first portion and a second portion, the first portion being a metallic oxide containing the metallic component, the second portion being carbon,
the processing gas is an inert gas, and
the first precursor is metal acetylide containing the metallic component.

11. The ALD device for the metallic film according to any one of claims 1, 2, 3, 4 and 10, further comprising a precursor generator used as both the first precursor generator and the second precursor generator, wherein
the precursor generator includes
a plasma generating means used as both the first plasma generating means and the second plasma generating means, and
a switching mechanism that switches between a state in which a plasma excited by the plasma generating means etches the target and a state in which the plasma does not etch the target, and
the precursor generator generates the first precursor by etching the target by the plasma, and generates the second precursor by not etching the target by the plasma.
